# EUROPEAN PATENT APPLICATION

(11) **EP 4 439 632 A1**
(43) Date of publication of application: **02.10.2024**
(21) Application number: 23164334.7
(22) Date of filing: 27.03.2023
(51) Int. Cl.: H01L 21/3063, H01L 21/04, H01L 29/78

(54) **SEMICONDUCTOR DEVICE AND ITS METHOD OF FABRICATION**

(71) Applicant: Hitachi Energy Ltd, 8050 Zürich (CH)
(72) Inventor: ALFIERI, Giovanni, 5103 Möriken (CH); ROMANO, Gianpaolo, 5400 Baden (CH); MIHAILA, Andrei, 5415 Rieden (CH); ARANGO, Yulieth Cristina, 8045 Zurich (CH); WEHRLE, Moritz, 8304 Wallisellen (CH)
(74) Representative: Epping - Hermann - Fischer

(57) **Abstract**

In at least one embodiment, the method is for producing a semiconductor device (1) and comprises:
A) providing a semiconductor body (2) which is based on a group IV-semiconductor material,
B) doping a first region (21) in the semiconductor body (2), the first region (21) is of a first conductivity type and starts from a surface (20) of the semiconductor body (2), and
C) forming a recess (3) in the semiconductor body (2) by selectively and wet-chemically etching the first region (21).

## Description

A method for manufacturing a semiconductor device is provided. A corresponding semiconductor device is also provided.

Document K. Kawahara et al., "Deep levels induced by reactive ion etching in n- and p-type 4H-SiC" in Journal of Applied Physics, Volume 108, 023706 (2010), DOI:10.1063/1.3460636, refers to energy levels in SiC.

Document T. Nakamura et al., "High performance SiC trench devices with ultra-low ron", 2011 International Electron Devices Meeting, December 2011, DOI:10.1109/IEDM.2011.6131619, refers to MOSFETs based on SiC.

Document M. Rashid et al., "Optical properties of mesoporous 4H-SiC prepared by anodic electrochemical etching", Journal of Applied Physics, Volume 120, 194303 (2016), DOI:10.1063/1.4968172, and document M. D. Pirnaci et al., "Systematic Characterization of Plasma-Etched Trenches on 4H-SiC Wafers" in ACS Omega, Volume 6, 20667 (2021), DOI: 10.1021/acsomega.1c02905, refer to properties of SiC related to handling of SiC.

Document H. K. Sung et al., "Vertical and bevel-structured SiC etching techniques incorporating different gas mixture plasmas for various microelectronic applications", Scientific Reports, Volume 7, 3915 (2017), DOI: 10.1038/s41598-017-04389-y, and Y. Ke et al., "Surface polishing by electrochemical etching of p-type 4H SiC", Journal of Applied Physics, Volume 106, 064901 (2009), DOI: 10.1063/1.3212541, refers to roughness resulting from etching of SiC.

An object to be achieved is to provide a method for efficiently producing semiconductor devices.

This object is achieved, inter alia, by a method and by a semiconductor device as defined in the independent patent claims. Exemplary further developments constitute the subject-matter of the dependent claims.

For example, with the method trenches in SiC trench MOSFETs are produced by ion implantation and selective wet etching of a region being subject to the ion implantation.

In at least one embodiment, the method is for producing a semiconductor device and comprises the following steps, for example, in the stated order:
A) providing a semiconductor body which is based on a group IV-semiconductor material,
B) doping one or a plurality of first regions in the semiconductor body, the at least one first region is of a first conductivity type and starts from a surface, for example, of the semiconductor body, and
C) forming a recess in the semiconductor body by selectively and wet-chemically etching the at least one first region.

Inductively coupled plasma reactive ion etching, ICP-RIE, is a selective dry etching fabrication process used to form trenches, mesas, etc. It relies on the deposition of a mask, it has good accuracy, reproducibility and can be employed in SiC device processing. Due to the chemical inertness of, for example, SiC, different types of plasmas may be used, typically chloride or fluoride, but also mixtures with oxygen and inert gases. Etching rates depend on the plasma, but also on a power employed, and range between 500 nm/min and 800 nm/min at most. Among the undesired effects of using ICP-RIE, there can be an unevenness at a bottom face of the SiC trenches, due to the reflection of plasma ions on sidewalls, for example. Such unevenness can appear on the sidewalls themselves, giving rise to micro-trenches. Such undesired effects can be avoided by extra processing steps, such sidewall passivation layers or by adding oxide to a Cl-based plasma. Another undesired effect may be the formation of carbon vacancies in an etched epilayer, that is, in an epitaxially grown semiconductor layer. Further, RIE may give rise to two electrically active levels labelled IN6 and EN at 1.0 eV and 1.6 eV below a conduction band edge, respectively, compare document K. Kawahara et al. as cited above.

Hence, to improve the semiconductor device, in the method described herein the SiC trench device is produced without using RIE.

Instead of RIE, in the method described herein ion implantation and electrochemical etching, ECE, for forming a trench is performed. ECE is a selective wet chemical etching method. ECE comprises dipping the region to be etched in a HF-based solution, for example. A SiC wafer may be used as anode in the solution. A current density can be varied to control an etch rate. Etching will occur only in regions of the correct conductivity type, that is, depending on the applied electric potential, and which are electrically conductive, for example, having a specific electric resistance of about 0.03 Ωcm, while leaving regions with a higher the higher specific electric resistance intact. By inverting a polarity of the applied electric potential, etching of a material with an opposite conductivity type is also feasible. Etching rates can be as high as 200 µm/h.

In the method described herein, unlike using RIE, no etching endpoint detection system is required as ECE stops when a differently doped area is reached. Further, unlike RIE, ECE of trenches avoids the formation of point defects like carbon vacancies, V_{C}. In addition, ECE leads to less roughness in the etched surface; for example, Cl-based RIE will lead to a surface roughness of about 60 nm to 70 nm, while ECE can lead to a surface roughness of about 2 nm to 7 nm, rout mean square, RMS.

By implantation, trenches of any depth and shape can be defined and then formed more quickly by ECE than by RIE.

For example, plasma-immersion ion implantation, PIII, after trench ECE can form electric field limiting layers and removes possible V_{C} formed by ion implantation.

With the method described herein, V-shaped trenches and the like can be manufactured by tilted ion implantation, for example, at an angle of 54.7° for the 0-33-8 plane.

Reverse engineering in the final product is possible by x-ray photoelectron spectroscopy, XPS. A distinct signature is present for ECE etched 4H-SiC, compared to RIE etched 4H-SiC, in the 280 eV to 290 eV energy range, see documents M. Rashid et al. and M. D. Pirnaci et al. as cited above.

Reverse engineering in the final product is possible by deep level transient spectroscopy, DLTS, too. After implantation in n-type SiC, the presence of the ON1, ON2, IN2 levels indicates that an ECE-based method was used, see T. Nakamura et al. as cited above. After implantation in p-type SiC, the presence of HK0, IP5, IP7, IP8 levels indicate that the ECE-based method was used, see also T. Nakamura et al. as cited above.

According to at least one embodiment, the group IV-semiconductor material, also referred to as group 14-semiconductor material, is C, like diamond, Si, Ge, or any mixture thereof, like SiC. Especially, the semiconductor material is SiC, like stoichiometric SiC.

According to at least one embodiment, the first region is defined by the doping. That is, all regions starting from a surface and being doped in step B) may be referred to as first region. That is, by the doping in step B) the first region is defined. It is however possible that a plurality of first regions are defined by the doping in step B), but that one or some of these first regions are not for being etched; such first regions may be covered by another material before step C). In the following, such regions covered by another material and not being configured for etching are not referred to as first region as such a region does not start from a surface as meant in the present context.

According to at least one embodiment, the recess in the semiconductor body is exclusively formed by the wet-chemically etching the first region. Hence, all material removal resulting in the recess originates from the wet-chemical etching.

According to at least one embodiment, the wet-chemical etching is a selective etching. This means, for example, that an etching rate during the wet-chemical etching of the first region is at least 10 times or is at least 100 times or is at least 10³ times or is at least 10⁴ times or is at least 10⁵ times higher than an etching rate of other regions of the semiconductor body exposed to an etching liquid used in the wet-chemical etching. Thus, "selectively" may mean that virtually only the at least one first region is etched, and that no significant material removal of other regions of the semiconductor body takes place.

According to at least one embodiment, the at least one first region exposed to the etching liquid is completely etched away. Thus, nothing of the respective at least one first region may remain in the finished semiconductor device.

According to at least one embodiment, the etching liquid is an acid or a solution comprising at least one acid. For example, the etching liquid is an HF-based solution. For example, the HF-based solutions is a 5% to 10% HF aqueous solution mixed with ethanol in a ration 1:1 or 2:1. Alternatively, HF(50%) :acetic acid:H2O in a ratio of 4:6:2 or 1:1:5 can be used, for example.

According to at least one embodiment, in the ECE the applied voltage is selected to that a current density is maintained at at least 10 mA/cm² and/or at at most 80 mA/cm².

According to at least one embodiment, method step B) includes:
B1) applying an electric potential at the semiconductor body so that at least part of the semiconductor body serves as an etching electrode, and
B2) removing the first region by means of electrochemical etching, ECE, as the wet-chemical etching.

Hence, ECE is used to selectively remove the at least one first region.

According to at least one embodiment, when the first conductivity type is p-conductive, the etching electrode is a cathode, or otherwise when the first conductivity type is n-conductive, the etching electrode is an anode. That is, in case of the first region is p-conductive, a negative voltage is applied at the semiconductor body, and correspondingly in case of the first region is n-conductive, a positive voltage is applied at the semiconductor body.

According to at least one embodiment, the etching electrode is formed by at least part of a semiconductor substrate of the semiconductor body. For example, said part is located at a side of the semiconductor body remote from the surface. For example, the surface is a top face of the semiconductor body opposite the substrate. The top face may be oriented perpendicular to a growth direction of an epilayer of the semiconductor body.

According to at least one embodiment, the first region has a first doping concentration which is at least a factor of 10 or at least a factor of 10² or at least a factor of 100 higher than a second doping concentration of a material of the semiconductor body adjacent to the first region and being also of the first conductivity type. Accordingly, the first region is embedded in a semiconductor material of the first conductivity type, too, but with lower doping concentration. Alternatively or additionally, adjacent to the first region the semiconductor body is of a second conductivity type different from the first conductivity type. For example, in the latter case the first region is n-doped and is embedded in a p-doped region, or vice versa. There can be a mixture of both afore-mentioned cases.

According to at least one embodiment, a specific electrical resistance of the first region is at most 10 Ωcm or is at most 1 Ωcm or is at most 0.1 Ωcm; the same may apply for the etching electrode. Accordingly, the first region can be considered to be electrically conductive, as is true for the etching electrode. If the semiconductor material of the semiconductor body adjacent to the first region is of the same, first conductivity type, then the specific electrical resistance of said adjacent semiconductor material is, for example, more than 10 Ωcm or is at least 0.1 kΩcm or is at least 1 kS2cm. The afore-mentioned values may apply to room temperature, that is, 293 K.

According to at least one embodiment, the etching electrode and the at least one first region are distant from one another. That is, the etching electrode and the at least one first region do not touch. For example, between the etching electrode and the at least one first region there can be a semiconductor material which is not conductive, that is, having a specific electrical resistance of more than 10 Ωcm or of at least 0.1 kS2cm or of at least 1 kS2cm. A distance between the etching electrode and the at least one first region may be at least 1 µm or at least 5 µm or at least 40 µm.

According to at least one embodiment, seen in cross-section perpendicular to the top side of the semiconductor body, the recess monotonically or strictly monotonically becomes narrower in a direction away from the top side. Monotonically means that a thickness t at a position x is the same or larger than a thickness t' at a position x + d further away from the top side: t(x) ≥ t'(x + d) where d is a distance larger than zero, d > 0. Accordingly, in case of strictly monotonically it applies t(x) > t' (x + d). This may apply on a real sidewall of the recess, or on a virtual sidewall of the recess being a best fit straight line through a roughening of the real sidewall, seen in cross-section perpendicular to the top side and/or perpendicular to a direction of main extend of the recess, the direction of main extend is determined in top view of the top side.

According to at least one embodiment, the recess is formed without reactive ion etching, RIE.

According to at least one embodiment, in step B) the first region is doped by means of ion implantation. Alternatively or additionally, in the step B) the doping is done by means of epitaxial growth.

According to at least one embodiment, the recess is a trench. For example, an aspect ratio of a maximum depth of the trench and a maximum width of the trench is at least 0.8 or is at least 1 or is at least 1.0 or is at least 2. Alternatively or additionally, said aspect ratio is at most 20 or is at most 10 or is at most 5.

According to at least one embodiment, the method further includes:
D) doping at least one second region of the second conductivity type in the semiconductor body directly exclusively or at least at a side of the recess or at a side of the first region remote from the surface. The at least one second region may be distant from or directly at the first region or the recess. The second region may thus be created by doping prior to etching the recess or also after etching the recess.

According to at least one embodiment, the second region is configured as a shielding region. That is, the second region is highly doped and can be electrically conductive. For `electrically conductive', see the definition above provided in context of the first region.

According to at least one embodiment, a maximum depth of the recess is at least 1 µm or is at least 5 µm or is at least 15 µm. Alternatively or additionally, the maximum depth is at most 0.1 mm or is at most 50 µm or is at most 30 µm.

According to at least one embodiment, a maximum doping concentration of the first region is at least 10¹⁸ cm⁻³ or is at least 5 × 10¹⁸ cm⁻³ or is at least 1 × 10¹⁹ cm⁻³. Alternatively or additionally, said doping concentration is at most 10²¹ cm⁻³ or is at most 5 × 10²⁰ cm⁻³.

According to at least one embodiment, the recess is formed in an epitaxially grown layer of the semiconductor body. As grown, all of said layer may be of the first conductivity type. For example, said layer has a doping concentration, as grown, of at most 10¹⁶ cm⁻³. or of at most 5 × 10¹⁵ cm⁻³. Alternatively or additionally, said doping concentration is at least 5 × 10¹⁴ cm⁻³ or is at least 1 × 10¹⁵ cm⁻³.

According to at least one embodiment, after the recess is formed, the method further comprises:
E1) applying an electrically insulating film onto walls of the recess, and
E2) providing a gate electrode in the recess.

Hence, the finished semiconductor device can include a gate electrode accommodated in the trench, that is, in the recess.

A semiconductor device is additionally provided. By means of the method, the semiconductor device may be produced as indicated in connection with at least one of the above-stated embodiments. Features of the semiconductor device are therefore also disclosed for the method and vice versa.

In at least one embodiment, the semiconductor device comprises a semiconductor body based on a group IV-semiconductor material, like Si or SiC, and the semiconductor device is one of a metal-insulator-semiconductor field-effect transistor, MISFET, a metal-oxide-semiconductor field-effect transistor, MOSFET, an insulated-gate bipolar transistor, IGBT or a reverse-conducting insulated-gate bipolar transistor, RC-IGBT. At least one recess is formed in the semiconductor body and a rout mean square, RMS, roughness of a bottom face of the recess is at most 15 nm or is at most 10 nm or is at most 7 nm and/or is at least 1 nm or is at least 2 nm. A gate electrode is located in the at least one recess.

According to at least one embodiment, the semiconductor device is one of a metal-insulator-semiconductor field-effect transistor, MISFET, a metal-oxide-semiconductor field-effect transistor, MOSFET, an insulated-gate bipolar transistor, IGBT or a reverse-conducting insulated-gate bipolar transistor, RC-IGBT.

A method and a semiconductor device described herein are explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:
- Figure 1: is a schematic block diagram of an exemplary embodiment of a method to produce semiconductor devices described herein,
- Figures 2: to 6 are schematic sectional views of method steps of an exemplary embodiment of a method to produce semiconductor devices described herein,
- Figure 7: is a schematic sectional view of a bottom face of a trench of an exemplary embodiment of a semiconductor device described herein,
- Figures 8: to 12 are schematic sectional views of method steps of an exemplary embodiment of a further method to produce semiconductor devices described herein,
- Figures 13: and 14 are schematic sectional views of method steps of an exemplary embodiment of a further method to produce semiconductor devices described herein,
- Figures 15: to 20 are schematic sectional views of method steps of an exemplary embodiment of a further method to produce semiconductor devices described herein,
- Figure 21: is a schematic sectional view of an exemplary embodiment of a semiconductor device described herein,
- Figure 22: is a schematic top view of various recesses for exemplary embodiments of semiconductor devices described herein, and
- Figure 23: is a schematic sectional view of various recesses for exemplary embodiments of semiconductor devices described herein.

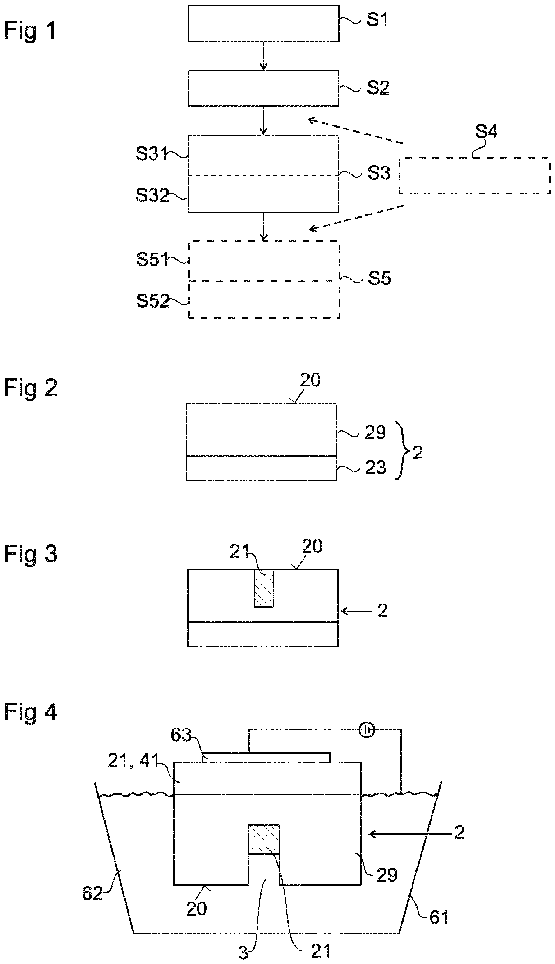

In Figure 1, a block diagram of a method for producing a semiconductor device 1 is shown. In a first method step S1, a semiconductor body 2 is provided, see also below Figure 2. The semiconductor body 2 is based a group IV-semiconductor material, like SiC or also like Si.

In a subsequent method step S2, a first region 21 is defined by doping part of the semiconductor body 2, see also Figure 3 below. The first region 21 is of a first conductivity type and starts from a surface 20 of the semiconductor body 2. Then, in method step S3, a recess 3 is formed in the semiconductor body 2 by selectively and wet-chemically etching the first region 21, see also Figure 4 below. As an option, method step S3 may comprise or consist of the two steps S31 and S32. In step S31, an electric potential is applied at the semiconductor body 2 so that the semiconductor body 2, or part of the semiconductor body 2, serves as an etching electrode 41 as indicated below in Figure 4. In step S32, the first region 21 is removed by means of electrochemical etching, ECE. The steps S31 and S32 may be performed simultaneously. The ECE can be a continuous etching or also a pulsed etching.

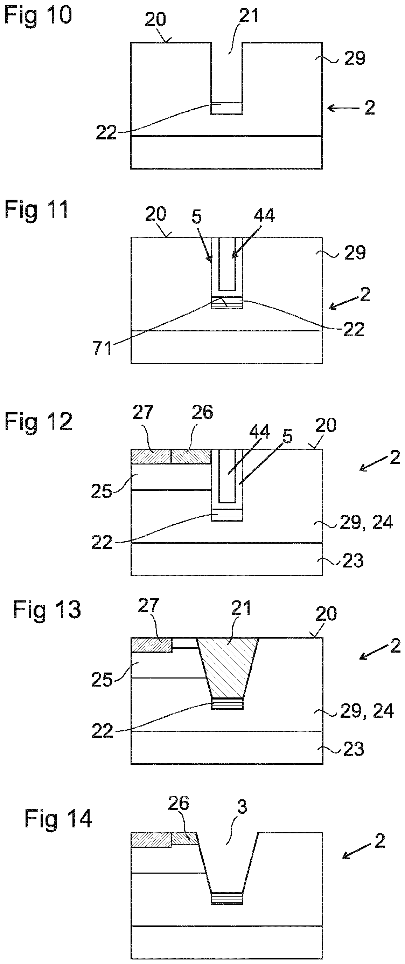

As a further option, there is a subsequent method step S5 in which a gate electrode 44 is produced, compare Figure 11 below. Step S5 may comprise steps S51 and S52. In step S51, an electrically insulating film 5 is applied onto walls and a bottom face of the recess 3. Afterwards, in step S52, a gate electrode material, like poly-Si, is applied in the recess 3 to create the gate electrode.

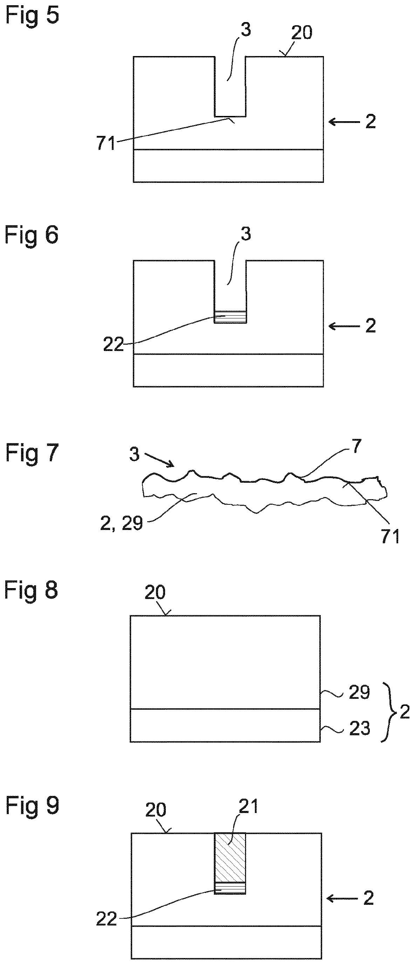

As a still further option, in a step S4 a second region 22 of the second conductivity type is created in the semiconductor body 2 by means of doping, for example, directly at a side of the recess 3 or at a side of the first region 21 remote from the surface 20, compare Figures 6 and 9 below, for example. Step S4 can be performed, for example, between steps S2 and S3 or also after step S3, like between steps S3 and S5.

In Figures 2 to 6, an example of the method is described in more detail. In Figure 2, the semiconductor body 2 is provided. For example, the semiconductor body 2 comprises a semiconductor substrate 23 made, for example, of highly n-doped SiC. On the semiconductor substrate 23, a layer 29 is epitaxially grown. For example, the layer 29 is made of moderately n-doped SiC. A main side of the layer 29 remote from the substrate 23 is a top side 20 and corresponds to the surface 20 as referred to in Figure 1.

Then, in the step of Figure 3, the first region 21 is applied in the epitaxially grown layer 29. In cross-section, the first region 21 may be of rectangular shape. Perpendicular to the plane of the drawing of Figure 3, the first region 21 may extend in a straight manner. The first region 21 terminates distant from the substrate 23.

For example, the first region 21 is formed by means of ion implantation with a box profile. The term 'box profile' may also be referred to as multiple energy implantation profile. Hence, a doping concentration in the first region 21 may be approximately constant, for example, is within 0.5 times and twice or within 0.75 times and 1.3 times a mean doping concentration. Hence, the first region 21 is electrically conductive but the rest of the epilayer 29 which is of the same conductivity type as the first region 21 and having an exposed surface is only semiconducting so that by the ECE only the conductive material of the correct conductivity type is etched with a high selectivity.

In Figure 4 it is shown that selective etching is performed. Hence, the first region 21 is put into and exposed to an etching liquid 62 in an etching tube 61. An external electrode 63 for etching is applied at the substrate 23 that serves as the etching electrode 41 of the semiconductor body 2, and a voltage is applied between the etching liquid 62 and the etching electrode 41. In case of an n-conductive first region, the etching electrode 41 is an anode as illustrated schematically in Figure 4.

In Figure 4, the first region 21 is shown to be only partially removed as the etching is still in progress, but after the etching is completed, see Figure 5, the first region 21 is completely removed. Thus, the shape of the resulting recess 3 is defined by the shape of the area doped in the step of Figure 3.

According to Figure 6, after the recess 3 is formed, optionally the second region 22 of the second conductivity type is produced. This is done, for example, by ion implantation through the recess 3. The recess 3 may be referred to as a trench extending perpendicular to the plane of drawing of Figure 6.

Thus, for example, starting with the 10 µm to 100 µm thick n-type 4H-SiC epilayer 29 with a doping concentration of 1 × 10¹⁵ cm⁻³ to 1 × 10¹⁶ cm⁻³, implantation with N, P, B and/or Al is carried out in order to obtain an implanted dopant concentration of about 1 × 10¹⁸ cm⁻³ to 1 × 10²⁰ cm⁻³ for the first region. An implantation energy or implantation energies for producing the first region 21 is/are chosen between 100 keV and 100 MeV, to form trenches 0.2 µm to 90 µm deep, for example. After implantation, activation may be performed at about 1600 °C or at about 1700 °C for 30 min, for example. Once the n⁺ or p⁺ first region 21 is formed in the epilayer 29, ECE is carried out and the trench 3 is formed by the ECE.

The electric field limiting layer, that is, the second region 22, may then be formed, for example, by an ion beam technique: thus, starting with the n-type epilayer 29, p⁺ or n⁺ implantation and activation is carried out to produce the first region 21. According to Figures 2 to 6, n⁺ implantation is used for the first region 21 by way of example. The electric field limiting layer 22 can be formed by implanting p⁺, if the first region 21 is of n⁺ type, or vice versa. After activation of the dopants, the n⁺ first region 21 is etched by ECE and this will result in the trench 3 with the exposed p⁺ region 22 at the bottom 71. Accordingly, the second region 22 can be formed after ECE, as indicated in Figure 6, or also prior to ECE.

Optionally, after trench ECE in the n-type epilyer 29, plasma immersion ion implantation of C can be carried out at room temperature, for example, using an energy of 5 keV to 10 keV and a dose between 10¹⁵ cm⁻² and 10¹⁶ cm⁻². This will inject carbon atoms in the epilayer 29 in order to remove carbon vacancies throughout said layer 29.

In Figures 2 to 6, only one trench 3 is shown for simplicity. Contrary to that, of course there can be multiple trenches 3, and a plurality of the semiconductor devices 1 may be produced simultaneously. It is possible that trenches 3 of different shapes, for example, of different depths, are produced at the same time because etching terminates at the respective trench 3 automatically when the assigned first region 21 is completely removed. The same applies to all other examples.

Otherwise, the same as to Figure 1 may also apply to Figures 2 to 6, and vice versa.

It is noted that Cl-based RIE, used for SiC etching, leads to a surface roughness ranging between 60 nm to 70 nm, whereas ECE can a achieve a surface roughness of only 2 nm to 7 nm, see, for example, H. K. Sung et al. and Y. Ke et al. as cited above. Thus, ECE offers much better surface roughness and, hence, improved electrical behaviour. This is illustrated in Figure 7 in which the roughening 7 at the bottom face 71 of the recess 3 has an RMS value of below 10 nm.

Otherwise, the same as to Figures 1 to 6 may also apply to Figure 7, and vice versa.

In Figures 8 to 12, another example of the method is described. In Figure 8, the semiconductor body 2 is provided, analogously to Figure 2. Then, both the first region 21 and the second region 22 are formed by ion implantation wherein the first region 21 is of n⁺ type and the second region 22 is of p⁺ type, see Figure 9.

According to Figure 10, the n⁺ type first region 21 is completely removed. ECE automatically stops at the p⁺ type second region 22 because of the applied voltage, and the n⁻type epilayer 29 is not etched because of being insufficient electrically conductive.

Then, see Figure 11, an electrically insulating film 5 is applied at the walls of the trench 3 and also at the bottom face 71. Subsequently, the gate electrode 44 is applied in the remainder of the trench 3.

Finally, see Figure 12, the semiconductor body 2 is finished by producing the p type well region 25, the p⁺ type plug region 27 and the n⁺ type source region 26, for example, by means of ion implantation.

Not shown, subsequently, further electrodes, passivation layers and protection layers as well as bond pads or the like can be produced.

Hence, a SiC trench MOSFET can be manufactured using the above method. For example, first, the SiC epilayer 29 grown on the n⁺ type substrate 29 is provided. High dose P and Al implantation, for example, at 200 °C to 600 °C, are carried out, in any order, followed by activation at above 1600 °C, in order to form the first and second regions 21, 22. Once the n⁺ type and p⁺ type first and second regions 21, 22 are formed, ECE is carried out, using a polarity that removes only the n⁺ type implanted area. The remaining p⁺ type region will be used as the field limiting layer 22. Alternatively, the p⁺ type implantation can be carried out after ECE of the n⁺ type first region 21. In either cases, the formation of the p⁺ type second region may be followed by C plasma ion implantation, for example, PIII, at 5 keV to 30 keV, with a dose of 10¹² cm⁻² to 10¹⁶ cm⁻². In this way, possibly previously formed carbon vacancies are removed. After this, the trench is filled with SiO₂ and then poly-Si for the gate electrode 44. At last, the regions 25, 26, 27 are formed.

Otherwise, the same as to Figures 1 to 7 may also apply to Figures 8 to 12, and vice versa.

By the method using implantation followed by ECE described herein, it is also possible to fabricate a V-trench MOSFETs, compare Figures 13 and 14. Starting from a 4H-SiC epilayer 29, the p⁺ type plug region 27, the p⁺ type second region 22, the p type well region 25 and the n⁺ type first region 21 formed by implantation. The n⁺ type first region 21 is formed by tilted implantation, for example, with an angle of 54.7°, of N or P, see Figure 13, along the 0-33-8 plane of SiC.

After that, by ECE the n⁺ type first region 21 is etched away, as indicated in Figure 14, and C PIII can be carried out. Finally, the n⁺ type source region 26 is formed, by implantation and activation. Analogously to Figure 11, then the trench 3 can also be coated with SiO₂, and the gate electrode can be applied.

Otherwise, the same as to Figures 1 to 12 may also apply to Figures 13 and 14, and vice versa.

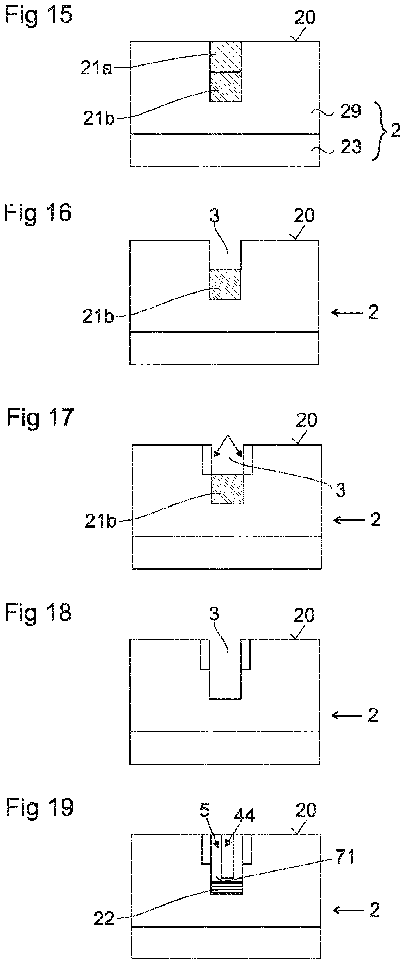

A further example of the method is illustrated in Figures 15 to 20. Thus, another possibility is the use of Al or B PIII for the formation of a channel without the use of ion implantation. n⁺ type and p⁺ type implantation for the first region 21a, 21b are carried out in the epilayer 29, see Figure 15. The region 21a next to the top side 20 is of p⁺ type and the deeper lying region 21b is of n⁺ type.

Then, ECE follows for the removal of the p⁺ type region 21a next to the top side 20, see Figure 16. Once this is done, PIII of Al is performed, for example, with 5 keV to 30 keV and a dose from 10¹² cm⁻² to 10¹⁴ cm⁻², as shown in Figure 17, see the arrows pointing to the walls of the trench 3. Afterwards, ECE is done to remove the n⁺ type region 21b, see Figure 18.

Then, the field limiting second region 22 at the bottom face 71 of the trench 3 is formed, see Figure 19. The trench 3 is also filled with an oxide and poly-Si for the electrically insulating film 5 and the gate electrode 44, respectively.

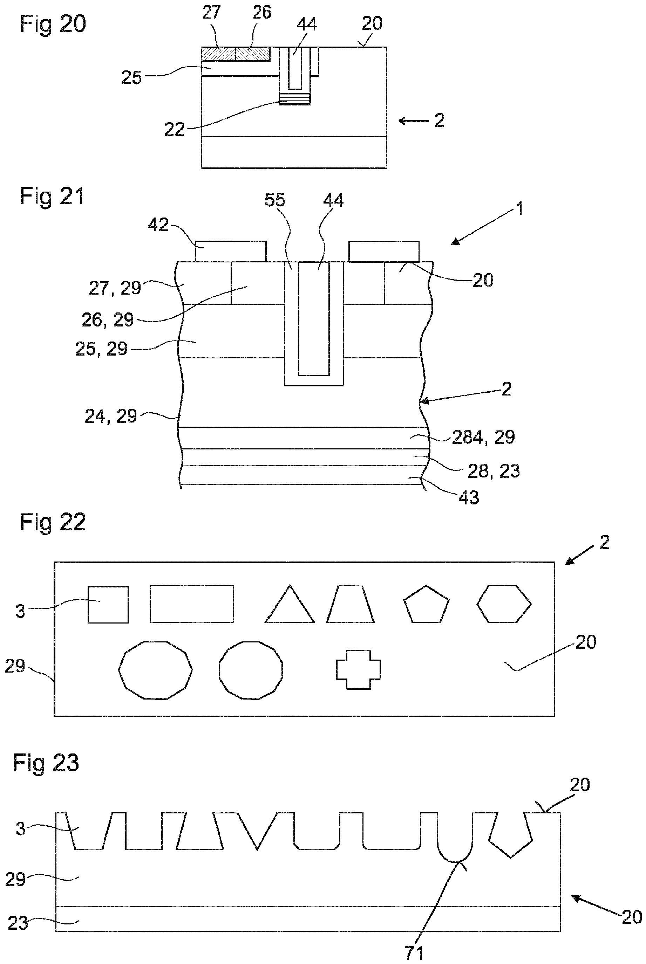

Finally, the p⁺ type plug region 27, the p type well region 25 and the n⁺ type source region 26 are formed, as illustrated in Figure 20.

Otherwise, the same as to Figures 1 to 14 may also apply to Figures 15 to 20, and vice versa.

In Figure 21, the finished semiconductor device 1 is schematically shown wherein only one trench 3 is illustrated. As is possible in all other examples, the regions 25, 26, 27, 28 may be arranged at both sides of the trench 3.

According to Figure 20, the semiconductor device 1 is an insulated insulated-gate bipolar transistor, IGBT, or also a metal-insulator-semiconductor field-effect transistor, MISFET, or metal-oxide-semiconductor field-effect transistor, MOSFET. In case of an IGBT, the region 25 is a well region. In the well region 25, there is the p⁺ plug region 27 which is, for example, at a first electrode 42 which is, for example, an emitter electrode. Further, in the well region 25 there is the n⁺ region 26 configured as an emitter region. The region 24 is thus an n⁻ drift region. A doping concentration of the drift layer 24 is, for example, about 2 × 10¹⁴ cm⁻³.

As an option, below the drift region 24 there is a further layer 284 of the semiconductor body 2 which can be a buffer region. For example, the buffer region 284 is n-doped with a maximum doping concentration of about 1 × 10¹⁸ cm⁻³. A thickness of the buffer region 284 may be between 2 µm and 10 µm inclusive, for example.

A further region 28 of the semiconductor body 2 is located at a side of the drift region 24 remote from the top side 20 or at a side of the buffer region 284 remote from the top side 20. The further region 28 is a collector region which is of the same conductivity type as the plug region 27. The collector region 28 has, for example, a doping concentration of about 1 × 10¹⁹ cm⁻³. A second electrode 43 at the collector region 28 is a collector electrode.

Analogously, the semiconductor device 1 can be the MISFET or the MOSFET. In this case, the region 284 may be omitted, and the region 28 is an n-doped drain region having, for example, a maximum doping concentration of at least 1 × 10¹⁸ cm⁻³ or at least 5 × 10¹⁸ cm⁻³ or at least 1 × 10¹⁹ cm⁻³ and/or of at most 5 × 10²⁰ cm⁻³ or at most 2 × 10²⁰ cm⁻³ or at most 1 × 10²⁰ cm⁻³. In this case, the region 26 is a source region and the first and second electrodes 42, 43 are a source electrode and a drain electrode, respectively.

Otherwise, the same as to Figures 1 to 20 may also apply to Figure 21, and vice versa.

In Figure 22 it is illustrated that by means of the doping of the first region 21 various geometries of the recess 3 can be realized, seen in top view. For example, seen in top view, the recess 3 is of square, rectangular, trigonal, trapezoid, pentagonal, hexagonal, octagonal or polygonal shape or can even be shaped as a cross. Although in Figure 22 regular trigonal, pentagonal, hexagonal, octagonal and polygonal shapes are shown, also irregular shapes with different angles at the corners can be used. Any combination of, for example, the shapes illustrated in Figure 22 can be realized.

Accordingly, compare Figure 23, by means of the doping and subsequent ECE of the first region 21, the resulting recess can have different cross-sectional shapes. Again, any combination of shapes in the same semiconductor device 1 is possible, analogously to Figure 22.

For example, seen in cross-section, the recess is of symmetric or asymmetric trapezoidal shape widening or narrowing towards the top side 20, is of trigonal shape or of square shape or of rectangular shape or also of pentagonal shape with a tip pointing away from the top side. Further, sharp and rounded corners are possible. Moreover, a U-shaped trench 3 with a curved bottom face 71 is also possible.

Otherwise, the same as to Figures 1 to 21 may also apply to Figures 22 and 23, and vice versa.

The components shown in the figures follow, unless indicated otherwise, exemplarily in the specified sequence directly one on top of the other. Components which are not in contact in the figures are exemplarily spaced apart from one another. If lines are drawn parallel to one another, the corresponding surfaces may be oriented in parallel with one another. Likewise, unless indicated otherwise, the positions of the drawn components relative to one another are correctly reproduced in the figures.

The invention described here is not restricted by the description on the basis of the exemplary embodiments. Rather, the invention encompasses any new feature and also any combination of features, which includes in particular any combination of features in the patent claims, even if this feature or this combination itself is not explicitly specified in the patent claims or exemplary embodiments.

### List of Reference Signs

- 1: semiconductor device
- 2: semiconductor body
- 20: surface (top side)
- 21: first region (etching defining region)
- 22: second region (shielding region)
- 23: semiconductor substrate
- 24: drift region
- 25: well region
- 26: source region/emitter region
- 27: plug region
- 28: drain region/collector region
- 284: buffer region
- 29: epitaxially grown layer
- 3: recess (trench)
- 41: etching electrode
- 42: first electrode (source electrode, emitter electrode)
- 43: second electrode (drain electrode, collector electrode)
- 44: gate electrode
- 5: electrically insulating film
- 61: etching tube
- 62: etching liquid
- 62: external electrode for etching
- 7: roughening
- 71: bottom face of the recess
- S..: method step

## Claims

1. A method for producing a semiconductor device (1) comprising:
A) providing a semiconductor body (2) which is based on a group IV-semiconductor material,
B) doping a first region (21) in the semiconductor body (2), the first region (21) is of a first conductivity type and starts from a surface (20) of the semiconductor body (2), and
C) forming a recess (3) in the semiconductor body (2) by selectively and wet-chemically etching the first region (21).

2. The method according to the preceding claim,
wherein step B) includes:
B1) applying an electric potential at the semiconductor body (2) so that the semiconductor body (2) serves as an etching electrode (41), and
B2) removing the first region (21) by means of electrochemical etching, ECE,
wherein when the first conductivity type is p-conductive, the etching electrode (41) is a cathode, or otherwise when the first conductivity type is n-conductive, the etching electrode (41) is an anode, and
wherein the group IV-semiconductor material is SiC.

3. The method according to the preceding claim,
wherein the etching electrode (41) is formed by part of a semiconductor substrate (23) of the semiconductor body (2) at a side of the semiconductor body (2) remote from the surface (20) .

4. The method according to any one of the preceding claims, wherein one or both of the following applies:
- the first region (21) has a first doping concentration which is at least a factor of 10² higher than a second doping concentration of a material of the semiconductor body (2) adjacent to the first region (21) and being also of the first conductivity type, or
- adjacent to the first region (21), the semiconductor body (2) is of a second conductivity type different from the first conductivity type.

5. The method according to any one of the preceding claims, wherein, seen in cross-section perpendicular to a top side (20) of the semiconductor body (2), the recess (3) monotonically or strictly monotonically becomes narrower in a direction away from the top side (20).

6. The method according to any one of the preceding claims, wherein the recess (3) is formed without reactive ion etching, RIE.

7. The method according to any one of the preceding claims, wherein in step B) the first region (21) is doped by means of at least one of ion implantation or epitaxial growth.

8. The method according to any one of the preceding claims, wherein the recess (3) is a trench,
wherein an aspect ratio of a maximum depth of the trench and a maximum width of the trench is at least 1 and is at most 10.

9. The method according to any one of the preceding claims, wherein the method further includes:
D) doping a second region (22) of the second conductivity type in the semiconductor body (2) directly at a side of the recess (3) or at a side of the first region (21) remote from the surface (20),
wherein the second region (22) is configured as a shielding region.

10. The method according to any one of the preceding claims, wherein
- the maximum depth of the recess (3) is at least 5 µm and is at most 50 pm,
- a maximum doping concentration of the first region (21) is at least 10¹⁸ cm⁻³ and is at most 10²¹ cm⁻³.

11. The method according to any one of the preceding claims, wherein the recess (3) is formed in an epitaxially grown layer (29) of the semiconductor body (2) which is of the first conductivity type and which has a doping concentration, as grown, of at most 10¹⁶ cm⁻³.

12. The method according to any one of the preceding claims, wherein after the recess (3) is formed, the method further comprises:
E1) applying an electrically insulating film (5) onto walls of the recess (3), and
E2) providing a gate electrode (44) in the recess (3).

13. The method according to any one of the preceding claims, wherein the finished semiconductor device (1) is one of a metal-insulator-semiconductor field-effect transistor, MISFET, a metal-oxide-semiconductor field-effect transistor, MOSFET, an insulated-gate bipolar transistor, IGBT or a reverse-conducting insulated-gate bipolar transistor, RC-IGBT.

14. A semiconductor device (1) comprising a semiconductor body (2) based on a group IV-semiconductor material which is one of a metal-insulator-semiconductor field-effect transistor, MISFET, a metal-oxide-semiconductor field-effect transistor, MOSFET, an insulated-gate bipolar transistor, IGBT or a reverse-conducting insulated-gate bipolar transistor, RC-IGBT,
wherein a recess (3) is formed in the semiconductor body (2) and a rout mean square, RMS, roughness of a bottom face (71) of the recess (3) is at most 15 nm, and
wherein a gate electrode (44) is located in the recess (3).

15. The semiconductor device (1) according to the preceding claim,
which is produced by the method according to any one of claims 1 to 12, and
wherein the group IV-semiconductor material is SiC.
